# EUROPÄISCHE PATENTSCHRIFT

(11) **EP 0 715 005 B1**
(45) Veröffentlichungstag und Bekanntmachung des Hinweises auf die Patenterteilung: **17.03.1999**
(21) Anmeldenummer: 95118840.8
(22) Anmeldetag: 30.11.1995
(51) Int. Cl.: C30B 15/00, C30B 29/06

(54) **Vorrichtung und Verfahren zur Herstellung eines Einkristalls**
Apparatus and process for producing single crystal
Dispositif et procédé pour produire un monocristal

(30) Priorität: 01.12.1994 DE 4442829
(43) Veröffentlichungstag der Anmeldung: 05.06.1996
(73) Patentinhaber: Wacker Siltronic Gesellschaft für Halbleitermaterialien Aktiengesellschaft, 84489 Burghausen (DE)
(72) Erfinder: Vilzmann, Peter, D-84489 Burghausen (DE); Pinzhoffer, Helmut, D-84367 Tann (DE)
(74) Vertreter: Rimböck, Karl-Heinz, Dr.

(56) Entgegenhaltungen:
- EP-A- 0 340 941
- EP-A- 0 608 875

## Beschreibung

Die Erfindung betrifft eine Vorrichtung und ein Verfahren zur Herstellung eines Einkristalls aus Silicium nach der Czochralski-Methode. Wesentliches Merkmal dieser Methode ist, daß ein monokristalliner Impfkristall in einem von der Umgebung abgeschlossenen Rezipienten mit schmelzflüssigem Material, das in einem Tiegel bereitsteht, in Kontakt gebracht und mit einer bestimmten Geschwindigkeit von der Schmelze weggezogen wird, wobei an seiner Unterseite ein Einkristall auf zuwachsen beginnt. Viele Ziehanlagen sind mit einem den wachsenden Einkristall abschirmenden, rohr- bis konusförmigen Körper ausgestattet. In der Patentschrift US-4,330,362 ist ein den Einkristall abschirmender Körper beschrieben, der sich zur Schmelze hin konisch verjüngt, was ihm ein topfähnliches Aussehen verleiht. Solche den wachsenden Einkristall über seine gesamte Länge oder einen Teil davon konzentrisch umschließende Körper schirmen Wärmestrahlung, die von der Tiegelwand ausgeht, ab. Eine Folge davon ist, daß der Einkristall mit einer höheren Geschwindigkeit gezogen werden kann.

In der EP-340 941 A1 ist ein den Einkristall abschirmender Körper dargestellt, der eine Öffnung aufweist, durch die Silicium in den Tiegel nachchargiert wird.

Während des Ziehens eines Einkristalls wird laufend Siliciummonoxid gebildet, das als Gas in den Rezipientenraum oberhalb der Schmelze entweicht. Der Rezipient wird mit Inertgas gespült, um zu verhindern, daß sich das Siliciummonoxid an kalten Teilen im Tiegelbereich der Ziehanlage als Feststoff niederschlagen, zur Kristallisationsfront am Einkristall gelangen und Versetzungen im Kristall verursachen kann. Es ist üblich, Inertgas zur Oberfläche der Schmelze zu leiten und zusammen mit entstandenem Siliciummonoxid aus dem Rezipienten abzusaugen. Ein den Einkristall abschirmender Körper teilt den Rezipientenraum oberhalb der Schmelze in einen inneren und einen äußeren Teil. Ein Inertgasstrom zum Entfernen von Siliciummonoxid wird in der Regel durch den inneren Teil des Rezipientenraums zur Oberfläche der Schmelze geleitet. Er gelangt dann zwischen dem unteren Ende des Abschirmkörpers und der Oberfläche der Schmelze in den äußeren Teil des Rezipientenraums und schließlich zu einer in der Rezipientenwand vorgesehenen Absaugöffnung.

Gemäß der Offenbarung der EP-608 875 A1 kann der Gasstrom in zwei unterschiedliche Teilströme geteilt werden.

Bei der Herstellung von mit Antimon oder Arsen dotierten Kristallen fällt auf, daß bestimmte, einen hohen Dotierstoffgehalt im Einkristall fordernde Produkt-Spezifikationen, kaum oder nur in sehr geringer Ausbeute zu erreichen sind. Der Einbau von Dotierstoff in hohen Konzentrationen wird umso schwieriger, je größer der Durchmesser des wachsenden Einkristalls ist. Der Dampfdruck der genannten Dotierstoffe in flüssigem Silicium ist ziemlich hoch, so daß die Schmelze rasch an Dotierstoff verarmt. Es wurde daher versucht, die Schmelze mit Dotierstoff zu übersättigen, um ein Dotierstoffdefizit zu umgehen. Leider begünstigen solche Maßnahmen das Entstehen von Versetzungen im Einkristall, der dann in einer zeitaufwendigen Prozedur zurückgeschmolzen werden muß, bevor weitergezogen werden kann. Zwischenzeitlich hat in der Regel wieder soviel Dotierstoff den Tiegel verlassen, daß die geforderte Rate, mit der Dotierstoff in das Kristallgitter eingebaut werden soll, nicht mehr erreicht werden kann.

Die Aufgabe der nachstehend beschriebenen Erfindung bestand deshalb darin, die Herstellung von Einkristallen aus Silicium nach der Czochralski-Methode so zu verbessern, daß auch Einkristalle mit hohem Arsen- oder Antimongehalt ohne Schwierigkeiten und mit guter Ausbeute hergestellt werden können.

Gegenstand der vorliegenden Erfindung ist eine Vorrichtung zur Herstellung eines Einkristalls aus Silicium nach der Czochralski-Methode, mit einem mit Inertgas spülbaren Rezipienten, einem darin untergebrachten Tiegel zur Aufnahme einer Schmelze, einer Vorrichtung zum Ziehen eines Einkristalls aus der Schmelze und einem, den wachsenden Einkristall abschirmenden, rohr- bis konusförmigen Körper, der an seinem unteren Ende als kreisringförmige Abschirmblende ausgebildet ist und der den Rezipientenraum oberhalb der Schmelze in einen inneren Teil und einen äußeren Teil trennt, wobei Inertgas, das in den inneren Teil des Rezipientenraums zur Schmelze geleitet wird, zwischen dem unteren Ende des Körpers und der Oberfläche der Schmelze in den äußeren Teil des Rezipientenraums gelangt, die dadurch gekennzeichnet ist, daß der Körper eine Seitenwand mit mindestens einer Öffnung aufweist, durch die Inertgas direkt vom inneren Teil in den äußeren Teil des Rezipientenraums gelangen kann, und sich die Öffnung in der unteren Hälfte der Seitenwand des Körpers befindet.

Gegenstand der Erfindung ist auch ein Verfahren zur Herstellung eines Einkristalls aus Silicium nach der Czochralski-Methode, umfassend:
Ziehen eines Einkristalls in einem Rezipienten aus einer in einem Tiegel bereitgestellten Schmelze, wobei der Einkristall von einem ihn abschirmenden, rohr- bis konusförmigen Körper umgeben ist, der den Rezipientenraum oberhalb der Schmelze in einen inneren Teil und einen äußeren Teil trennt;
Leiten eines Inertgasstroms durch den inneren Teil des Rezipientenraums zur Oberfläche der Schmelze und zwischen dem, als kreisringförmige Abschirmblende ausgebildeten, unteren Endedes Körpers und der Oberfläche der Schmelze in den äußeren Teil des Rezipientenraums, wobei das Verfahren
dadurch gekennzeichnet ist, daß
ein Teil des Inertgasstroms durch mindestens eine Öffnung in der unteren Hälfte der Seitenwand des Körpers direkt vom inneren in den äußeren Teil des Rezipientenraums geleitet wird.

Überraschenderweise genügen die vorgeschlagenen Verfahrens- und Vorrichtungsänderungen, um die bisher aufgetretenen Schwierigkeiten bei der Herstellung hoch antimon- oder arsendotierter Einkristalle aus Silicium zu umgehen. Die Erfindung ist besonders zur Herstellung von Einkristallen mit Durchmessern über 100 mm von Vorteil, da die Schmelze, aus der Einkristall gezogen wird, nicht wie bisher, über den Sättigungsgrad hinaus mit Dotierstoff konzentriert werden muß. Darüber hinaus ist festzustellen, daß das Verfahren auch den Einbau von Sauerstoff in den Einkristall beeinflußt und deshalb allgemein für die Herstellung von Einkristallen aus Silicium von Bedeutung ist. Dieser zusätzliche Effekt ist unabhängig von der Art und der Menge absichtlich zugeführter Dotierstoffe und tritt zum Beispiel auch bei einer Dotierung mit Bor oder Phosphor auf. Er äußert sich darin, daß der im fertiggestellten Einkristall gemessene Sauerstoffgehalt in Abhängigkeit der Zahl und der Größe der Öffnungen variiert. Es kann sowohl Einfluß auf den absoluten Betrag des vom Einkristall aufgenommenen Sauerstoffs genommen werden, als auch auf den axialen Verlauf der Sauerstoffkonzentration im Einkristall. So läßt sich beispielsweise eine mehr oder weniger stark von der Spitze zum Ende des Einkristalls sinkende Sauerstoffkonzentration erreichen.

Eine mögliche Erklärung dafür, daß die Erfindung vorallem die Herstellung antimon- und arsendotierter Einkristalle aus Silicium vereinfacht, ist, daß die Strömungsverhältnisse im Gasraum über der Oberfläche der Schmelze günstig beeinflußt werden.

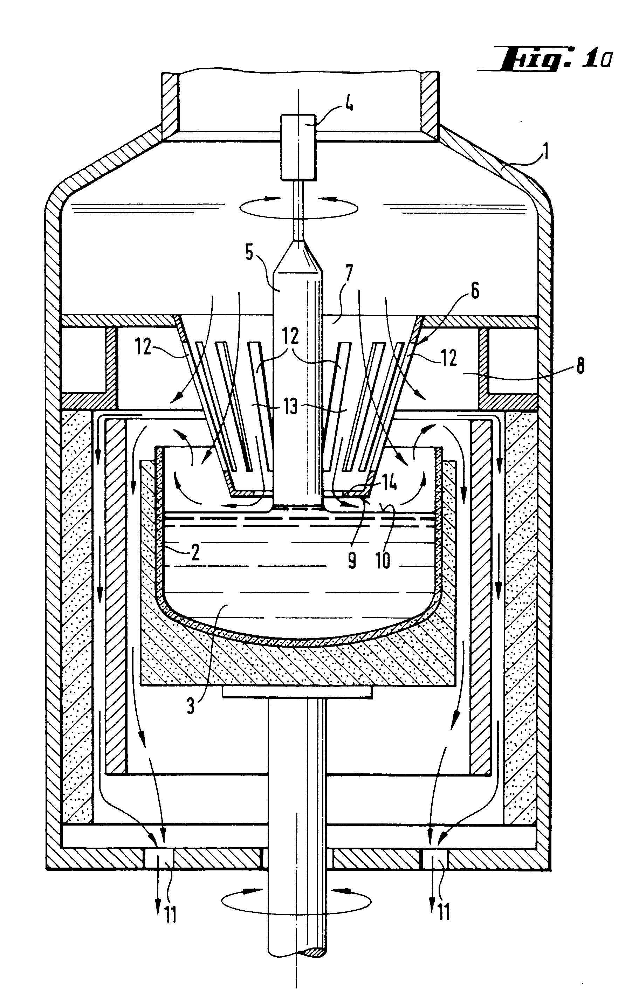

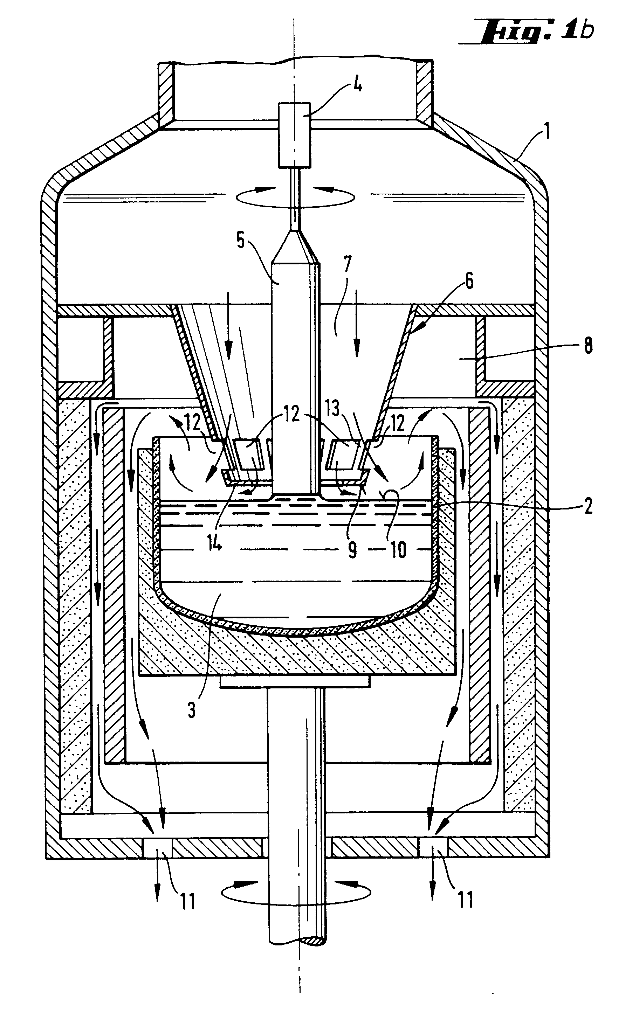

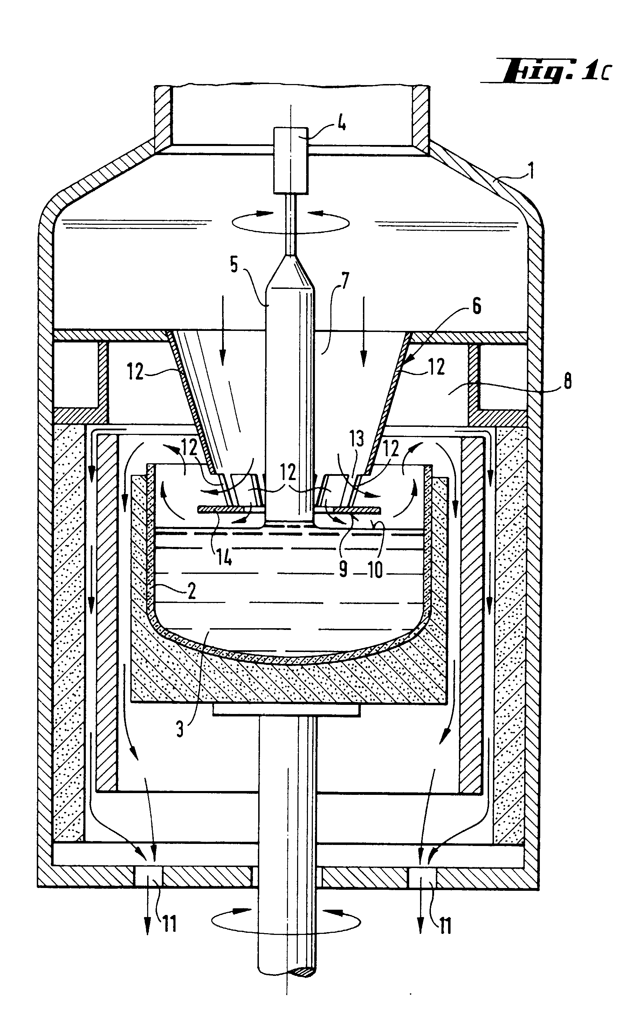

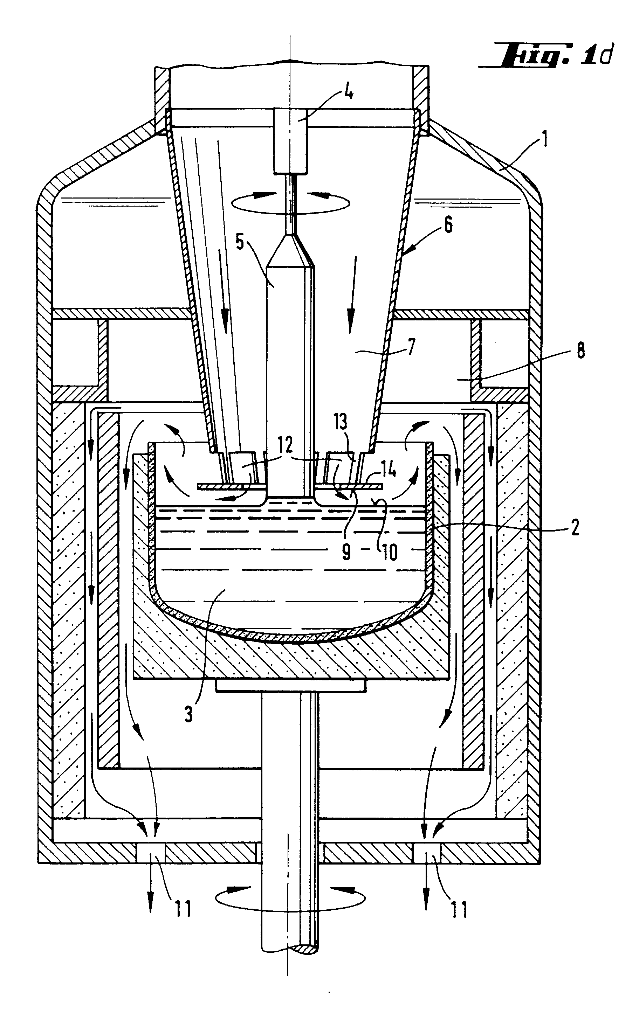

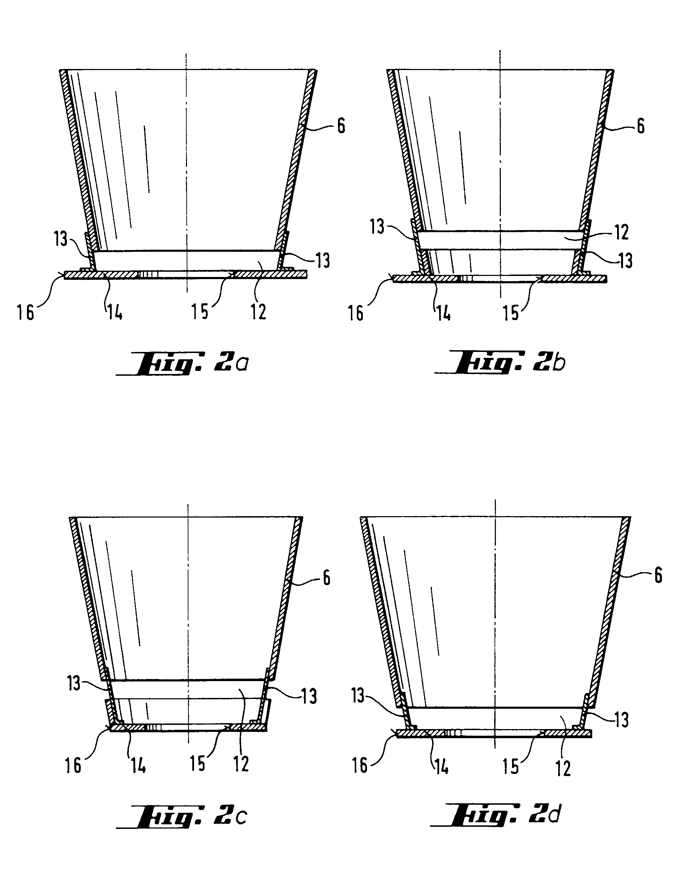

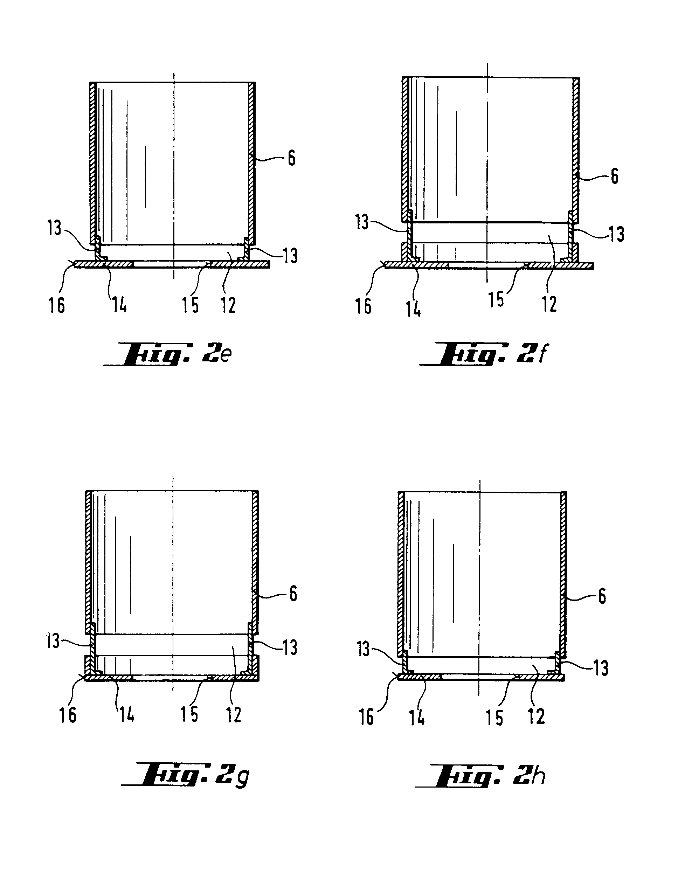

Im folgenden wird die Erfindung mit Hilfe mehrerer Figuren näher erläutert. Die Figuren la)-d) zeigen jeweils einen Längsschnitt durch eine Anlage zum Herstellen von Einkristallen nach der Czochralski-Methode. Es sind nur die zum Verständnis der Erfindung notwendigen Merkmale dargestellt. Die Figuren 2a)-h) zeigen Längsschnitte durch bevorzugte Ausführungsformen des den Einkristall abschirmenden Körpers. Gleiche, in verschiedenen Figuren verwendete Bezugsziffern verweisen auf gleiche Vorrichtungsmerkmale. Zunächst wird auf die Figuren la)-d) Bezug genommen. Die erfindungsgemäße Vorrichtung besteht aus einem Rezipienten 1, der einen mit geschmolzenem Silicium und gegebenenfalls zugesetzten Dotierstoff gefüllten Tiegel 2 beherbergt. Aus der Schmelze 3 wird mit Hilfe einer Ziehvorrichtung 4 ein Einkristall 5 gezogen. Der Einkristall ist von einem ihn abschirmenden, rotationssymmetrischen Körper 6 umschlossen, der den Rezipientenraum oberhalb der Schmelze in einen inneren Teil 7 und einen äußeren Teil 8 aufteilt. Der Abstand zwischen dem unteren Ende 9 des Körpers und der Oberfläche 10 der Schmelze beträgt vorzugsweise 5 bis 50 mm, so daß Inertgas, das wie in den Figuren la)-d) durch Pfeile angedeutet, in den inneren Teil 7 des Rezipientenraums geleitet wird, durch den Zwischenraum zwischen dem unteren Ende 9 des Körpers und der Oberfläche 10 der Schmelze in den äußeren Teil 8 des Rezipientenraums gelangen kann. Der weitere Weg des Inertgasstroms vom äußeren Teil 8 des Rezipientenraums bis zu einer oder mehreren Absaugöffnungen 11 in der Wand des Rezipienten ist ebenfalls mit Pfeilen angedeutet. Der den Einkristall abschirmende Körper 6 kann Rohr- oder Konusform besitzen. Bei einem konusförmigen Körper wird der Abstand zwischen dem Einkristall und der Innenwand des Körpers bis zum unteren Ende des Körpers immer kürzer. Bei einem rohrförmigen Körper bleibt dieser Abstand über die gesamte Höhe des Körpers unverändert. Die Höhe des Körpers ist im Zusammenhang mit der vorliegenden Erfindung von untergeordneter Bedeutung, vorausgesetzt, daß eine gewisse Mindesthöhe überschritten und sichergestellt ist, daß die besonders heißen Bereiche des wachsenden Einkristalls durch den Körper abgeschirmt werden. Beispielsweise erstreckt sich der in Figur 1d) dargestellte Körper 6 von der oberen Begrenzung des Rezipienten 1 bis in den Tiegel 2. Gemäß der vorliegenden Erfindung ist die den Einkristall umgebende Seitenwand des Körpers nicht vollkommen geschlossen, sondern weist in ihrer unteren Hälfte mindestens eine Öffnung 12 auf, durch die der in den inneren Teil des Rezipientenraums zur Oberfläche 10 der Schmelze geleitete Inertgasstrom teilweise direkt in den äußeren Teil 8 des Rezipientenraums gelangt. Durch die Gesamtfläche der Öffnung kann ein bestimmtes Teilungsverhältnis eingestellt werden, mit dem der Inertgasstrom in Teilströme aufgeteilt wird, die den inneren Teil 7 des Rezipientenraumes auf unterschiedliche Weise verlassen.

Es ist bevorzugt, daß der durch die Öffnung 12 im Körper 6 strömende Teilstrom radial gleichmäßig verteilt in den äußeren Teil des Rezipientenraums gelangt. So können mehrere Öffnungen, beispielsweise Lochbohrungen, in gleichen Abständen auf einer Umfangslinie des Körpers vorgesehen sein. Gemäß der in Figur la) gezeigten Ausführungsform besteht die Öffnung 12 im Körper 6 aus einer Vielzahl von Schlitzen, die in regelmäßigen Abständen um den Umfang des Körpers angeordnet sind. Besonders bevorzugte Ausführungsformen des den Einkristall abschirmenden Körpers sind in den Figuren 2a)-h) gezeigt. Als Öffnung in der Seitenwand des Körpers ist ein Schlitz 12 vorgeschlagen, der einer Umfangslinie des Körpers folgt und nur von Befestigungsstreben 13, die den unteren Teil des Körpers tragen, unterbrochen wird. Es können auch zwei oder mehrere übereinander angeordnete Schlitze vorgesehen sein. Die bevorzugte Schlitzbreite beträgt 5 bis 50 mm. Das untere Ende des den Einkristall abschirmenden Körpers ist als kreisringförmige Abschirmblende 14 ausgebildet, die parallel zur Oberfläche der Schmelze beabstandet ist. Die Ausführungsformen gemaß Figur 2 a), d), e) und h) unterscheiden sich von den übrigen gezeigten Ausführungsformen in der Lage des Schlitzes 12 relativ zur Oberfläche der Abschirmblende.

Durch die Ausgestaltung der Abschirmblende kann zusätzlich Einfluß auf die Strömungsverhältnisse im Rezipientenraum oberhalb der Schmelze genommen werden. Bevorzugt ist, daß der innere Rand 15 der Abschirmblende in den inneren Teil des Rezipientenraums ragt und 10 bis 80 mm an den Einkristall heranreicht. Der Außendurchmesser der Abschirmblende kann so gewählt sein, daß die Abschirmblende mit ihrem äußeren Rand 16 in den äußeren Rezipientenraum ragt und beispielsweise 10 bis 80 mm an die Innenwand des Tiegels heranreicht. Der Außendurchmesser der Abschirmblende sollte jedoch nicht kleiner gewählt werden als der Außendurchmesser des zylindrischen oder konusförmigen Teils des Körpers, der auf der Oberfläche der Abschirmblende aufliegt (Ausführungsformen gemäß Figur 2 c) und g)) oder zu dieser Oberfläche zeigt (Ausführungsformen gemäß Figur 2 d) und h)).

## Patentansprüche

1. Vorrichtung zur Herstellung eines Einkristalls aus Silicium nach der Czochralski-Methode, mit einem mit Inertgas spülbaren Rezipienten, einem darin untergebrachten Tiegel zur Aufnahme einer Schmelze, einer Vorrichtung zum Ziehen eines Einkristalls aus der Schmelze und einem, den wachsenden Einkristall abschirmenden, rohr- bis konusförmigen Körper, der an seinem unteren Ende als kreisringförmige Abschirmblende ausgebildet ist und der den Rezipientenraum oberhalb der Schmelze in einen inneren Teil und einen äußeren Teil trennt, wobei Inertgas, das in den inneren Teil des Rezipientenraums zur Schmelze geleitet wird, zwischen dem unteren Ende des Körpers und der Oberfläche der Schmelze in den äußeren Teil des Rezipientenraums gelangt, dadurch gekennzeichnet, daß der Körper eine Seitenwand mit mindestens einer Öffnung aufweist, durch die Inertgas direkt vom inneren Teil in den äußeren Teil des Rezipientenraums gelangen kann, und sich die Öffnung in der unteren Hälfte der Seitenwand des Körpers befindet.

2. Vorrichtung nach Anspruch 1, dadurch gekennzeichnet, daß die öffnung in der Seitenwand des Körpers als Schlitz ausgebildet ist, der einer Umfangslinie des Körpers folgt.

3. Verfahren zur Herstellung eines Einkristalls aus Silicium nach der Czochralski-Methode, umfassend:
Ziehen eines Einkristalls in einem Rezipienten aus einer in einem Tiegel bereitgestellten Schmelze, wobei der Einkristall von einem ihn abschirmenden, rohr- bis konusförmigen Körper umgeben ist, der den Rezipientenraum oberhalb der Schmelze in einen inneren Teil und einen äußeren Teil trennt;
Leiten eines Inertgasstroms durch den inneren Teil des Rezipientenraums zur Oberfläche der Schmelze und zwischen dem, als kreisringförmige Abschirmblende ausgebildeten, unteren Ende des Körpers und der Oberfläche der Schmelze in den äußeren Teil des Rezipientenraums, dadurch gekennzeichnet, daß
ein Teil des Inertgasstroms durch mindestens eine Öffnung in der unteren Hälfte der Seitenwand des Körpers direkt vom inneren in den äußeren Teil des Rezipientenraums geleitet wird.

## Claims

1. Apparatus for preparing a single crystal made of silicon according to the Czochralski method, comprising a receiver which can be purged with inert gas, a crucible accommodated therein for holding a melt, a device for pulling a single crystal from the melt and a tubular to conical body which shields the growing single crystal, is fashioned at its lower end as an annular screen and divides the receiver chamber above the melt into an inner portion and an outer portion, inert gas which is conducted into the inner portion of the receiver chamber towards the melt passing between the lower end of the body and the surface of the melt into the outer portion of the receiver chamber, characterized in that the body has a side wall with at least one orifice through which inert gas is able to pass directly from the inner portion into the outer portion of the receiver chamber, and the orifice is located in the lower half of the side wall of the body.

2. Apparatus according to Claim 1, characterized in that the orifice in the side wall of the body is fashioned as a slot which follows a perimeter of the body.

3. Method for preparing a single crystal made of silicon in accordance with the Czochralski method, which comprises:
pulling of a single crystal in a receiver from a melt provided in a crucible, the single crystal being surrounded by a tubular to conical body which shields it and divides the receiver chamber above the melt into an inner portion and an outer portion;
conducting an inert gas stream through the inner portion of the receiver chamber towards the surface of the melt and between the lower end, fashioned as an annular screen, of the body and the surface of the melt into the outer portion of the receiver chamber, characterised in that
a portion of the inert gas stream is conducted through at least one orifice in the lower half of the side wall of the body directly from the inner portion into the outer portion of the receiver chamber.

## Revendications

1. Dispositif pour produire un monocristal de silicium suivant le procédé Czochralski, avec un récipient pouvant être purgé par du gaz inerte, un creuset qui y est logé pour recevoir de la matière en fusion, un dispositif pour tirer un monocristal à partir de la matière en fusion et un corps tubulaire à conique, protégeant le monocristal croissant, qui se présente à son extrémité inférieure sous la forme d'un écran protecteur annulaire et qui sépare la chambre du récipient au-dessus de la matière en fusion en une partie intérieure et une partie extérieure, le gaz inerte, qui est amené dans la partie intérieure de la chambre du récipient vers la matière en fusion, passant entre l'extrémité inférieure du corps et la surface de la matière en fusion dans la partie extérieure de la chambre du récipient, caractérisé en ce que le corps comprend une paroi latérale pourvue d'au moins un orifice, par lequel le gaz inerte peut directement passer de la partie intérieure à la partie extérieure de la chambre du récipient, et l'orifice se trouve dans la moitié inférieure de la paroi latérale du corps.

2. Dispositif suivant la revendication 1, caractérisé en ce que l'orifice est formé dans la paroi latérale du corps sous forme de fente qui suit une ligne de circonférence du corps.

3. Procédé pour produire un monocristal de silicium suivant le procédé Czochralski, comprenant :
le tirage d'un monocristal dans un récipient à partir d'une matière en fusion préparée dans un creuset, le monocristal étant entouré d'un corps tubulaire à conique qui le protège, et qui sépare la chambre du récipient au-dessus de la matière en fusion en une partie intérieure et une partie extérieure;
l'amenée d'un flux de gaz inerte par la partie intérieure de la chambre du récipient vers la surface de la matière en fusion et entre l'extrémité inférieure du corps, qui se présente sous la forme d'un écran protecteur annulaire, et la surface de la matière en fusion dans la partie extérieure de la chambre du récipient, caractérisé en ce
qu'une partie du flux de gaz inerte est amenée, par au moins un orifice dans la moitié inférieure de la paroi latérale du corps, directement de la partie intérieure dans la partie extérieure de la chambre du récipient.
